Europäisches Patentamt

European Patent Office

Office européen des brevets

(11) Publication number:

**0 385 638**

**A2**

# EUROPEAN PATENT APPLICATION

(21) Application number: 90301834.9

(51) Int. Cl.5: **G02F 1/015, H01L 27/14**

(22) Date of filing: 21.02.90

(30) Priority: **28.02.89 US 316887**

(43) Date of publication of application:
**05.09.90 Bulletin 90/36**

(84) Designated Contracting States:
**DE FR GB IT NL SE**

(71) Applicant: **AMERICAN TELEPHONE AND TELEGRAPH COMPANY**
**550 Madison Avenue**
**New York, NY 10022(US)**

(72) Inventor: **Bar-Joseph, Israel**
**c/o Weizmann Institute of Science, Dept of Physics**
**Rehovot 76100(IL)**
Inventor: **Chemla, Daniel S.**
**20 Robin Road**
**Rumson, New Jersey 07760(US)**
Inventor: **Goossen, Keith W.**
**29 Balmoral Arms**
**Matawan, New Jersey 07747(US)**
Inventor: **Kuo, Jenn-Ming**
**43 Meredith Road**
**Edison, New Jersey 08817(US)**

(74) Representative: **Watts, Christopher Malcolm Kelway, Dr. et al**
**Western Electric Company Limited 5,**
**Mornington Road**
**Woodford Green Essex, IG8 0TU(GB)**

(54) Semiconductor superlattice self-electrooptic effect device.

(57) While maintaining low switching energy and high contrast ratio, enhanced carrier sweep out and increased spectral range are achieved by a self-electrooptic effect device including a semiconductor superlattice (110) in the intrinsic region of a p-i-n diode (102). The semiconductor superlattice is realised by a series of interleaved barrier and well layers coupled by the resonant tunneling effect. The bandwidth of the conduction band and valence band of the superlattice is in the range of a few tens of millielectron volts, while the period falls in the range of a few nanometers.

FIG.1

## SEMICONDUCTOR SUPERLATTICE SELF-ELECTROOPTIC EFFECT DEVICE

### Technical Field

This invention relates to bistable optical devices, particularly, to a class of bistable optical devices known as self-electrooptic effect devices.

### Background of the Invention

Earlier, bistable optical devices suitable for computing and switching applications were based on an optical saturable absorber enclosed in a high finesse Fabry Perot cavity. Later, an optical bistable switching device known as a self-electrooptic effect device (SEED) was invented which dramatically reduced the optical energy required for switching. See U. S. Patent 4,546,244. SEED devices exhibit optical bistability as a result of utilizing a semiconductor material whose absorption coefficient increases with increasing optical excitation.

The optical bistable SEED device disclosed in the '244 patent comprised an interconnection of a p-i-n diode, including a multiple quantum well (MQW) in the intrinsic region, an electrical/electronic load and a bias voltage supply. Generally, the diode was reverse biased with the load while configured in a feedback loop with the voltage supply and load.

An electrical field applied perpendicular to the SEED device resulted in electroabsorption by the MQW due to the quantum confined Stark-effect (QCSE). An effect of electroabsorption was the shifting of the MQW's absorption band edge, including exciton resonance peaks, to lower photon energies, i.e., a longer wavelength. As the absorption band edge shifted toward the lower photon energy or a red portion of the light spectrum under the applied field, the transmissivity of the MQW at the wavelength of the exciton resonance peak changed differentially about 50% due to a decreased absorption. Generally, the contrast observed between high and low states of this device was sufficient to permit the fabrication of devices for switching, modulation and the like. See, for example, U. S. Patent 4,525,687.

At low optical power incident on the SEED device little, if any, photocurrent was generated, thereby resulting in a large voltage drop across the p-i-n diode. Wavelength of light incident on the device was selected to substantially coincide with the exciton resonance peak at zero applied field for peak absorption of light. Subsequent increase in the power of light incident on the device increased the photocurrent in the MQW and, in turn, reduced the voltage drop across the SEED device. Characteristic of the SEED device was that a reduced voltage increased the absorption resulting from the shift in exciton resonance peaks toward a lower photon energy. Any further increased absorption only increased the photocurrent which caused the device to switch to a low transmission state.

The devices described above have been characterized by a quantum well region having symmetric quantum wells to produce the desired absorption band edge shift under an applied field. Recently, in U. S. patent application Serial No. 298,591, a SEED device employing asymmetric quantum wells has been shown to produce bistability in which the absorption band edge shifts toward a higher photon energy, "blue shift", rather than a lower photon energy, "red shift", as in the prior art. In the asymmetric quantum well SEED, an asymmetric electronic characteristic due to dissimilar wave function confinement on either side of the quantum well (QW) is responsible for providing the "blue shift" in response to an increased applied filed.

In all the SEED devices described above, it has been possible to achieve switching speeds in the tens of nanoseconds regime without the requirement of a high finesse Fabry-Perot cavity. For these devices, switching speeds are limited in part because a space charge build-up due to hole accumulation restricts carrier mobility perpendicular to MQW layers. Switching speeds below tens of nanoseconds have not been reported in the literature. Such switching speeds are required in computing and communication applications which would benefit from the low loss, low switching energies and high contrast ratio of SEED devices.

While switching speeds is an important concern, it cannot be overlooked that prior art "red shift" SEED devices are wavelength sensitive. That is, they have a narrow spectral range of operation with respect to the wavelength of the incident light. The narrow spectral range results from requiring the wavelength incident on the device to substantially coincide with the wavelength at the exciton resonance peak. In practice, it is therefore necessary to include a Pelletier thermal element for tuning or shifting the wavelength of the exciton resonance peak of a "red shift" SEED device to coincide with the wavelength of the incident light.

### Summary of the Invention

While maintaining low switching energy and high contrast ratio, enhanced carrier sweep out and spectral range are achieved in accordance with the principles of the invention by a self-electrooptic effect (SEED) device including a semiconductor superlattice in the intrinsic region of a p-i-n diode. The semiconductor superlattice is realized by a series of thin interleaved semiconductor barrier and well layers having a wide and narrow bandgap energy, respectively. The resonant tunneling effect is exhibited in the semiconductor superlattice by a broadening of discrete energy levels of a single barrier or well layer into a continuous subband of energy levels. Under an applied electric field, the resonant tunneling effect is destroyed, thereby shifting the absorption band edge to a higher photon energy and, in turn, altering the transmissivity of the semiconductor superlattice for a wavelength near the absorption band edge. The contrast observed, comparable to prior art SEED devices, permits the fabrication of high speed and wide spectral range SEED devices.

## Brief Description of the Drawing

The invention will be more readily understood after reading the following detailed description of a specific illustrative embodiment of the invention in conjunction with the appended drawings wherein:

FIG. 1 shows a view of an exemplary embodiment of a semiconductor superlattice SEED in accordance with the principles of the invention;

FIGS. 2 and 3 are the energy-band diagrams of an exemplary embodiment of this invention under different levels of applied electric field;

FIG. 4 is a cross-sectional view of the semiconductor device in FIG. 1;

FIG. 5 is a schematic diagram showing the invention using a photodiode as the load;

FIG. 6 shows the variation in absorption with photon energy of the exemplary embodiment of this invention as shown in FIG. 5 under different levels of applied electric field; and

FIG. 7 is a graph showing the operating characteristics of the device shown in FIG. 5.

## Detailed Description

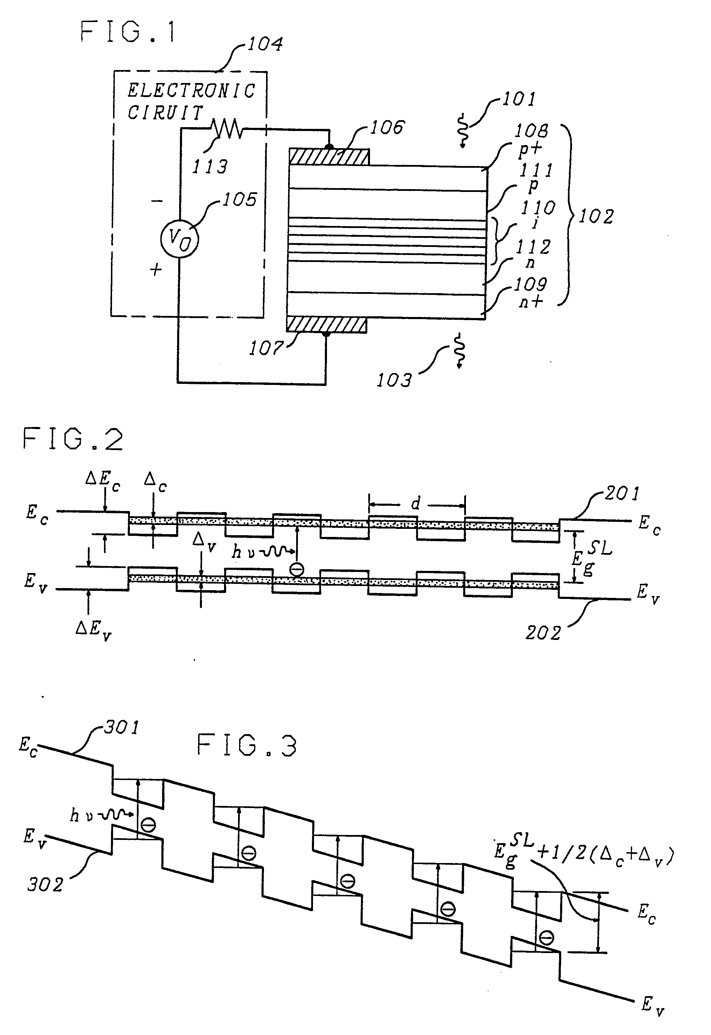

FIG. 1 shows a schematic of a semiconductor superlattice self-electrooptic effect device (SEED). Light beam 101 impinges on semiconductor device 102 and a portion of light beam 101 emerges as light beam 103. Semiconductor device 102 is biased, as shown in FIG. 1, by electronic circuit 104 including reverse bias voltage supply 105 connected in series with resistor 113 and semiconductor device 102. Alternatively, electronic circuit 104 may include transistors, phototransistors, photodiodes and the like in series or parallel with a voltage or current supply.

The optical characteristics of semiconductor device 102 are such that an increase in intensity of light beam 101 leads to an increased absorption coefficient by semiconductor device 102. Interconnection with electronic circuit 104 provides a positive feedback mechanism permitting an increased optical absorption of light energy by semiconductor 102, and, in turn, leading to an increased optical absorption coefficient. References made to the optical absorption coefficient is to be understood to encompass a reference in the alternative to the index of refraction vis-a-vis the Kramers-Kronig relationship.

Semiconductor device 102 in accordance with the principles of the invention operates by a different mechanism than the devices described in either the '244 patent or patent application Serial No. 298,591. A semiconductor device in the '244 patent included a symmetric quantum well region, relying on excitonic resonance peaks as the mechanism for obtaining decreasing absorption with increasing field. In patent application Serial No. 298,591, a semiconductor device achieved the desired shifting of absorption band edge by employing asymmetric quantum wells. The present semiconductor device distinguishes from either former devices by using thin interleaved barrier and well layers coupled by the resonant tunneling effect, commonly called a semiconductor superlattice, to produce absorption changes with field variations. Furthermore, carrier mobility is enhanced due to a lower effective barrier vis-a-vis the thin layers of the superlattice and, thereby, results in higher switching speed SEED devices.

As shown in FIG. 1, semiconductor device 102 is contacted by electrical pads 106 and 107 in order to facilitate an ohmic contact with electronic circuit 104. Electrical contact pads 106 and 107, although not limited to, are standard ring contacts which permit an unobstructed ingress and egress of light beam 101 and 103, respectively. Alternatively, contact pads 106 and 107 may be semitransparent electrodes instead of ring contacts. Semiconductor device 102 includes a p-i-n structure wherein regions 108 and 109 are heavily doped p and n, respectively, thereby ensuring ohmic contact to the p-i-n structure. Region 110 includes a semiconductor superlattice consisting of a series of interleaved semiconductor barrier and well layers having a wide and narrow bandgap energy, respectively. It is contemplated that the bandwidth of the conduction band, $\Delta E_c$, and valence band, $\Delta E_v$, of semiconductor superlattice 110 be in the range of a few tens of millielectron volts, while the period of the interleaved barrier and well layers, d, falls in the range of a few nanometers. In general, the barrier and well layers are sufficiently thin to produce the resonant tunneling effect in the semiconductor superlattice. A general treatment of semiconductor superlattices and quantum wells is given by L. Esaki in IEEE J. Quantum Electronics, vol. QE-22, No. 9, September 1986, pp. 1611-1624.

Semiconductor superlattice 110 is required to exhibit the resonant tunneling effect manifested as a broadening of a single well discrete energy levels into minibands energy levels of width $\Delta_c$ and $\Delta_v$, as shown in FIG. 2. A profile of the conduction band 201 and valence band 202 of semiconductor superlattice 110 is shown in FIG. 2 for zero applied field. The conduction and valence band are depicted as $E_c$ and $E_v$, respectively, while the interband transition energy is labeled $E_g^{SL}$. Due to the resonant tunneling effect, a miniband of energy levels $\Delta_c$ and $\Delta_v$ exists in the conduction band and in the valence band, respectively. For semiconductor device 102 operating with no applied field from electronic circuit 104, interband transitions occur between the bottom of the conduction miniband and the top of valence miniband as shown in FIG. 2. Furthermore, light at a photon energy greater than this interband transition energy is absorbed. Interband transitions are not localized to a few adjacent barrier and well layers, but extend throughout the semiconductor superlattice.

If a field, $F_{loc}$, greater than

$$\frac{\Delta_c}{ed},$$

, where e is the elementary charge $1.6 \times 10^{-19}$ coulombs, d is the period of the superlattice and $\Delta_c$ equals the miniband bandwidth, is applied from electronic circuit 104 via contact pads 108 and 107, the resonant tunneling effect is destroyed since energy levels in adjacent barrier and well layers become misaligned. As a result, energy states localize to a few adjacent barrier and well layers as shown in FIG. 3. This effect is known as Wannier-Stark localization. Resulting from Wannier-Stark localization, interband transitions shown in FIG. 3 are restricted to these regions and have an associated interband transition energy $E_g^{SL} + \frac{1}{2} (\Delta_c + \Delta_v)$. That is, the interband transition energy exceeds that energy without any applied field by an amount $\frac{1}{2}(\Delta_c + \Delta_v)$. Increased transition energy results in a "blue shift" of the absorption band edge. Thus, light having a photon energy greater than $Eg^{SL} + \frac{1}{2}(\Delta_c + \Delta_v)$, will only be absorbed. The "blue shift" is characteristic of the present invention. Such operation is completely opposite to that of "red shift" symmetric quantum well SEED devices disclosed in the '244 patent due to the structural dissimilarity between the intrinsic region of the devices. Although an asymmetric quantum well SEED device in U. S. patent application Serial No. 298,591 exhibits the "blue shift" phenomena, only the result not the the structure is similar. The "blue shift" phenomena observed in semiconductor superlattices allows decreasing absorption with increasing field without regard to exciton resonance peaks. As such it allows greater spectral range in the wavelength of light incident on the device. Moreover, a semiconductor superlattice has a greater carrier sweep out resulting in higher switching speeds. The blue shift phenomena in semiconductor superlattices are more fully disclosed in the following references: J. Bleuse and P. Voisin, Appl. Phys. Lett., 53(26), 2632, 1988; P. Voisin and J. Bleuse, Phys. Rev. Lett., 61 (14), 1639, 1988; E. E. Mendez, F. Agull-Rueda and J. M. Hong, Phys. Rev. Lett., 60(23), 2426, 1988; and J. Bleuse, G. Bastard and P. Voisin, Phys.. Rev. Lett., 60(3), 220, 1988.

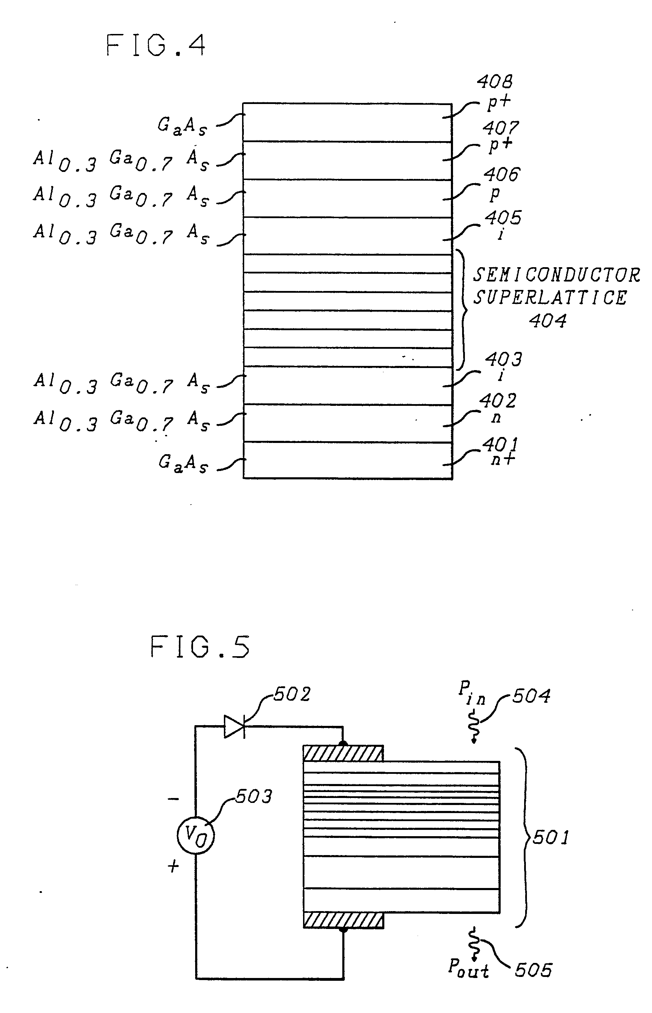

Semiconductor device 102 may be fabricated, for example, by a molecular beam epitaxy (MBE) growth technique. The device in FIG. 4 maybe substituted for semiconductor device 102. For the device shown in FIG. 4, the growth process is as follows. GaAs substrate 401 is doped with silicon to exhibit $n^+$ conductivity. Stop etch layer 402 of n doped $Al_{0.3}Ga_{0.7}As$ is grown on substrate 401 to a thickness of about 1.3μm. Epitaxially deposited on stop etch layer 402 is a $Al_{0.3}Ga_{0.7}As$ buffer layer which is intrinsic or nominally undoped having a thickness of 500Å. Semiconductor superlattice 404 grown on buffer layer 403 is a 100 period of interleaved 30Å GaAs well and 30Å $Al_{0.3}Ga_{0.7}As$ barrier layers, all layers with no intentional doping. An undoped or intrinsic layer 405 of $Al_{0.3}Ga_{0.7}As$ is grown on semiconductor superlattice 404 with a thickness approximately 500Å. Region 406 is grown on buffer region 405 to have a $Al_{0.3}Ga_{0.7}As$ contact layer of 0.5μm thickness exhibiting p type conductivity as a result of being doped with beryllium. Cap layer 407 doped similarly with beryllium has a $p^+$ type conductivity and a thickness of about 0.3μm. Contact region 408 of 1000Å thickness, $p^+$ GaAs is deposited on cap layer 407. Subsequently, the sample consisting of the substrate with the growth structure as described above was processed to form 200μm × 200μm square mesas by etching from contact layer 408 to stop etch layer 402. The sample was then bonded and epoxied to a sapphire substrate using transparent epoxy and an access hole etched through GaAs layer 401 to stop etch layer 402. The total thickness of the structure was approximately 2.9μm at the mesas and 1 .3μm in adjacent areas.

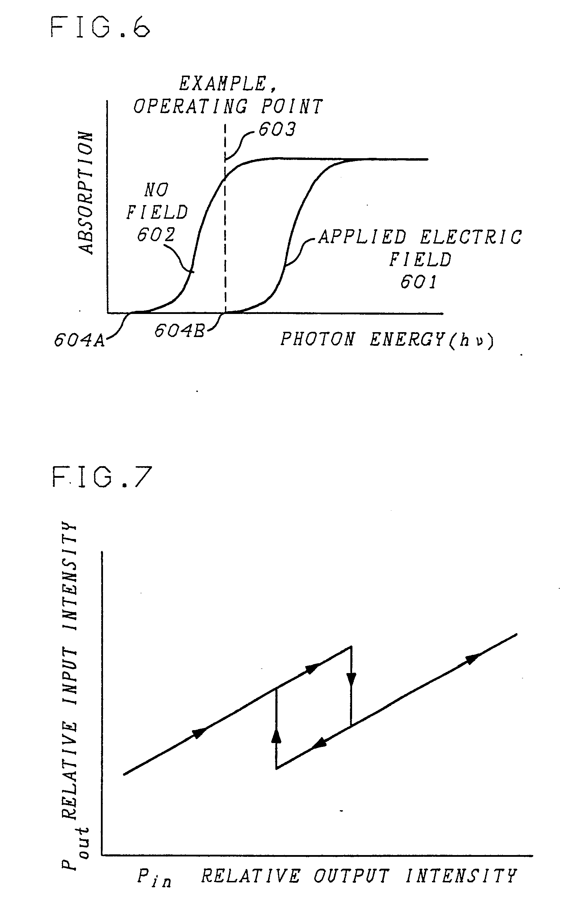

In one experiment using semiconductor device 501 similar to the structure illustrated in FIG. 4, a field strength of $7 \times 10^3$ V/cm applied to device 501 resulted in a "blue shift" of 25 meV. Furthermore, semiconductor device 501 having photodiode 502 as the electronic load was configured in an arrangement shown in FIG. 5. Light beam 504 has a wavelength 603 coincide with the absorption band edge 604B of semiconductor device 501 which is about 755 nm or 1.6 eV. The device biased at about -15V by voltage supply 503 was transparent to light beam 504. As the intensity of light beam 504 increased, photocurrent was generated by semiconductor device 501 and, in turn, reduced the voltage drop thereof. The reduced voltage across semiconductor device 501 shifted the absorption band edge from point 604B to point 604A as illustrated in FIG. 6, thereby causing a maximum absorption by semiconductor device 501 at wavelength 603. A hysteresis loop of this device is shown in FIG. 7. It is noticed that on the reverse path when the light intensity on the device is lowered, the switching to a transparent state occurs at a lower intensity than in a forward path direction. Furthermore, bistability was maintained over a wide spectral range of input light, almost constant between wavelengths from 745$\mu$m to 755$\mu$m.

Unlike either SEED devices incorporating symmetric or asymmetric quantum Bell regions, the present semiconductor device achieves improved carrier sweep out. The mobility of carriers perpendicular to the layers is not limited by a space charge build-up due to hole accumulation for the present device, but is rather enhanced due to a lower effective barrier for tunneling and thermionic emission resulting from the extended states delocalized in the semiconductor superlattice. It is estimated that the mobility of carriers is on the order of 5 to 10 times greater than in a symmetric SEED, thereby resulting in switching speed about an order of magnitude greater than prior art SEED devices. More importantly, a SEED device incorporating a semiconductor superlattice in accordance with the present invention affords the flexibility in engineering the bandgap of the device for a specific laser source. Currently, there is no SEED device operating at a wavelength of about 1.06$\mu$m, corresponding to YAG or YLF lasers which are among the most reliable and developed lasers. SEED device utilizing either InGaAsP/InP, InGaAlAs/InAlAs or GaSb/AlGaSb semiconductor superlattices which can have interband transitions at 1.06$\mu$m, 1.33$\mu$m and 1.55$\mu$m, respectively, can be fabricated to operate at wavelengths between 1.0 and 1.6$\mu$m, thus covering the range of Nd:YAG and Nd:YLF lasers.

In the present device, it is desirable that light beam 101 be a wavelength between the absorption band edges of semiconductor device 102 with and without an applied electric field. This is distinguished from "red" SEED devices in which the incident light must be tuned to the wavelength of the exciton resonance peak. Semiconductor device 102 does not rely on the resonance exciton peak, thereby allowing a wide spectral range for the wavelength of light incident on the device.

The descriptions given above are directed to a device wherein an electric field is applied perpendicular to the semiconductor superlattice and light impinging on the device is also perpendicular to the semiconductor superlattice. It is understood by those skilled in the art that light may be parallel to the semiconductor superlattice. It is also understood that other material system can be selected from either the III-V or II-VI systems, specifically InGaAs/InGaAlAs, GaSb/AlGaSb and InGaAsP/InP.

## Claims

1. A semiconductor device comprising: means responsive to light for generating a photocurrent, a structure having a semiconductor region, first and second semiconductor contact regions disposed on opposite sides of said semiconductor region, means responsive to said photocurrent for electrically controlling an optical absorption of said semiconductor region to vary in response to variations in said photocurrent, said semiconductor region including a semiconductor superlattice, said semiconductor superlattice comprising first and second layers, said first layers comprising a wide bandgap semiconductor material, said second layers comprising a narrow bandgap semiconductor material, said first layers interleaved with said second layers, said first and second layers being sufficiently thin to produce resonant tunneling of carriers in said semiconductor region, and said first and second semiconductor contact regions having dissimilar conductivity types.

2. A semiconductor device as defined in claim 1 wherein said means responsive to light for generating a photocurrent is said semiconductor region.

3. A semiconductor device as defined in claim 1 or claim 2 wherein said means responsive to said photocurrent applies an electrical field perpendicular to a layer plane of said semiconductor region.

4. A semiconductor device as defined in any of the preceding claims wherein said means responsive to said photocurrent includes electrical contacts to said first and second semiconductor contact regions.

5. A semiconductor device as defined in any of the preceding claims further comprising means for directing a beam of light substantially perpendicular to a layer plane of said semiconductor region.

6. A semiconductor device as defined in claim 5 wherein said beam of light has a photon energy substantially near the absorption band edge of said semiconductor superlattice.

7. A semiconductor device as defined in any of the preceding claims wherein said semiconductor superlattice consists of compounds selected from a GaAs/GaAlAs system.

8. A semiconductor device as defined in any of claims 1 to 6 wherein said semiconductor superlattice consists of compounds selected from an InGaAlAs/InAlAs system.

9. A semiconductor device as defined in any of claims 1 to 6 wherein said semiconductor superlattice consists of compounds selected from an InGaAsP/InP system.

FIG.1

ELECTRONIC
CIRUIT

113

105

$V_0$

104

106

101

108
p+
111
p
110
i
112
n
109
n+

102

107

103

FIG.2

$\Delta E_c$   $\Delta_c$

$E_c$

$d$

201

$E_c$

$\Delta_v$

$h\nu$

$\ominus$

$E_g^{SL}$

$E_v$

$E_v$

$\Delta E_v$

202

FIG.3

$E_c$

301

$h\nu$

$\ominus$

$E_v$

302

$E_g^{SL}+1/2(\Delta_c+\Delta_v)$

$E_c$

$\ominus$

$\ominus$

$\ominus$

$\ominus$

$\ominus$

$E_v$

# FIG.4

| | | |
|---|---|---|
| $GaAs$ | | 408 p+ |
| $Al_{0.3} Ga_{0.7} As$ | | 407 p+ |
| $Al_{0.3} Ga_{0.7} As$ | | 406 p |
| $Al_{0.3} Ga_{0.7} As$ | | 405 i |
| | | SEMICONDUCTOR SUPERLATTICE 404 |
| | | 403 i |
| $Al_{0.3} Ga_{0.7} As$ | | |
| $Al_{0.3} Ga_{0.7} As$ | | 402 n |
| $GaAs$ | | 401 n+ |

# FIG.5

$P_{in}$ 504

502

503 $V_0$

501

$P_{out}$ 505

## FIG.6

EXAMPLE,
OPERATING POINT
603

ABSORPTION

NO
FIELD
602

APPLIED ELECTRIC
FIELD
601

604A    604B    PHOTON ENERGY(hν)

## FIG.7

$P_{out}$ RELATIVE INPUT INTENSITY

$P_{in}$    RELATIVE OUTPUT INTENSITY